# EUROPEAN PATENT APPLICATION

(11) **EP 2 637 210 A1**
(43) Date of publication of application: **11.09.2013**
(21) Application number: 12158043.5
(22) Date of filing: 05.03.2012
(51) Int. Cl.: H01L 29/08, H01L 29/45, H01L 29/739, H01L 29/861

(54) **Power semiconductor device and method for manufacturing thereof**

(71) Applicant: ABB Technology AG, 8050 Zürich (CH)
(72) Inventor: Rahimo, Munaf, 5619 Uezwil (CH); Corvasce, Chiara, 8962 Bergdietikon (CH); Vobecky, Jan, 5600 Lenzburg (CH); Otani, Yoichi, 5616 Meisterschwanden (CH)
(74) Representative: ABB Patent Attorneys

(57) **Abstract**

A method for manufacturing a power semiconductor device is provided comprising the following steps:
- providing a wafer (1) of a first conductivity type, which wafer has a first main side (11) and a second main side (15) opposite to the first main side (11),
- applying on the second main side (15) at least one of a dopant of the first conductivity type for forming a layer (2) of the first conductivity type and a dopant of a second conductivity type for forming a layer (2) of the second conductivity type,
- afterwards depositing a metal deposition layer (3) with a metal having a melting point above 1300 °C on the second main side (15),
- annealing the metal deposition layer (3) so that simultaneously an intermetal compound layer (35) is formed at the interface between the metal deposition layer (3) and the wafer (1) and the dopant is diffused into the wafer (1),
- creating a first metal electrode layer (4) on the second side (15).

## Description

### Technical Field

The invention relates to the field of power electronics and more particularly to a method for manufacturing a power semiconductor device and a power semiconductor device as such.

### Background Art

### Modes for Carrying out the Invention

A prior art punch-through insulated gate bipolar transistor (IGBT) having a four-layer structure comprises a collector electrode on a collector side and an emitter electrode on an emitter side, which lies opposite the collector side. An (n-) doped drift layer is located between the emitter electrode and collector electrode. On the emitter side, a p doped base layer is arranged, which surrounds an n doped source region. These source region and base layer are in electrical contact with the emitter electrode. A gate electrode is also arranged on the emitter side (either planar gate or trench gate), which is electrically insulated from all other layers by an insulation layer.

An n doped buffer layer lies on the collector side between the base layer and the collector electrode. In the buffer layer, an electric field is stopped during operation of the device. On the buffer layer, towards the collector electrode, a p doped collector layer is arranged.

Such devices have been manufactured in former times by epitaxial growth of the buffer layer.

Such devices have been further developed into none punch-through (NPT) devices, in which no buffer layer is present and the p collector layer lies directly adjacent to the (n-) doped drift layer. Such devices offer several advantages in terms of the switching capability and current sharing of such chips which enabled the employment of IGBTs into high current modules.

Nevertheless, such devices need a thick wafer design due to the necessity to stop the electric field within the drift layer in the NPT concept. Therefore, such NPT devices suffer from higher static and dynamic losses.

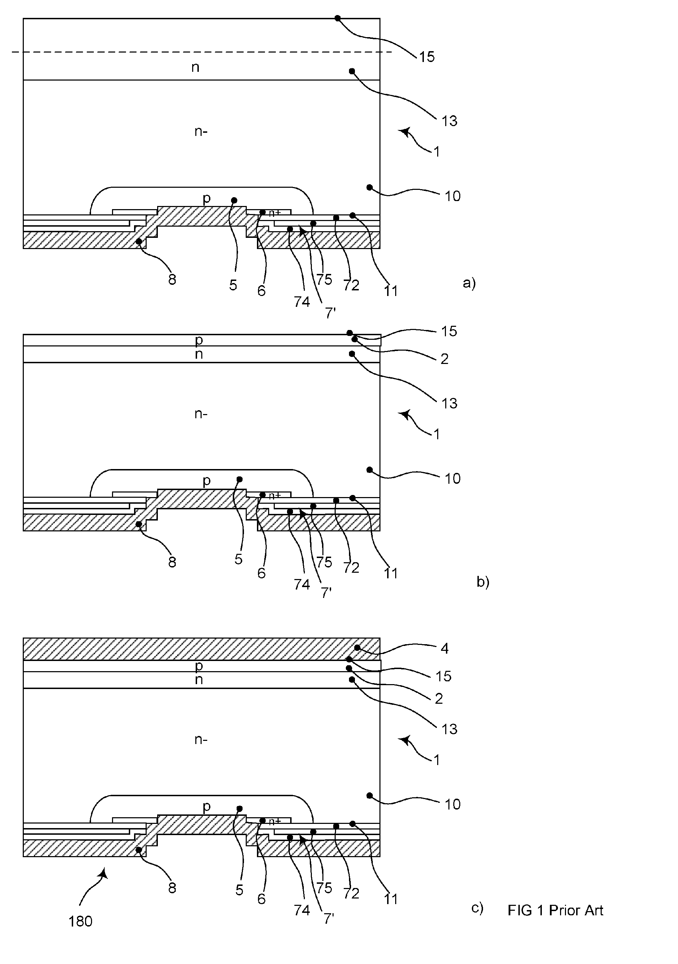

In order to improve the electrical properties of the IGBTs, soft-punch-through (SPT) devices have been introduced, which have thinner, but more highly doped buffer layers, thus resulting in thinner devices than the NPT devices, but without the disadvantages known from the previous PT devices. Such devices gave improvements in terms of losses. Nevertheless, the SPT concepts require complex processes when the wafer is thin, which is especially the case in low-voltage IGBTs for forming the backside layers including the collector and buffer layers. Such a method is for example known from DE 198 29 614 A1. It describes a fabrication method for a soft punch-through insulated gate bipolar transistor (IGBT) 180 element (FIG 1c)) based on a PT type which makes it possible to fabricate relatively thin semiconductor elements without having to employ the epitaxy method. For this purpose, a buffer layer 13 having a greater thickness than electrically necessary is introduced into a lightly doped wafer, process steps for embodying the layers on the emitter sided surface (first main side 11) of the semiconductor element are then carried out (like base layer 5, source regions 6, gate electrode 7' with its electrically conductive layer 75 and insulating layers 72, 74). Afterwards, the thickness of the buffer layer is reduced on the second main side 15 to the electrically required size by grinding or polishing (dotted line in FIG 1 a). Thus, it is possible to carry out the emitter sided process steps on a relatively thick wafer, thereby reducing the risk of breaking. Nevertheless, by virtue of the subsequent thinning of the wafer, a semiconductor element having the desired small thickness can be produced. The minimum thickness of the finalized semiconductor elements is no longer limited by a minimum thickness that can be achieved for its starting material. Afterwards a p dopant is implanted and diffused for forming a collector layer 2 (FIG 1 b) and then a first electrode layer 4 is created on the second main side 15 (FIG 1c)).

In US 6,482,681 B1 another punch-through (PT) insulated gate bipolar transistor (IGBT) is described. The device is produced by using an (n-) doped wafer, on top of which all processes for manufacturing layers on the emitter side, also called cathode side are finished, i.e. all junctions and metallizations on the emitter side are produced. Afterwards, the wafer is thinned and hydrogen ions are implanted on the collector side of the wafer, also called anode side for forming an n+ doped buffer layer. Then a p dopant is implanted for forming a collector layer. The wafer is then annealed at 300 to 400 °C in order to activate the hydrogen ions without damage to the structure on the emitter side. Thus, the buffer layer serves, in the blocking case, for abruptly decelerating the electric field before the collector layer is reached and thus keeping the electric field away from said collector layer, since a semiconductor element can be destroyed if the electric field reaches the collector layer.

After thinning the device a p dopant is implanted for forming the p-type collector layer and activated by laser annealing followed by multi metal depositions and finally a sinter process below 400°C is made in a conventional furnace to activate the anode and form a good contact to the collector electrode. This process is limiting for achieving good control of the p-type anode collector activation. However, due to the restriction of the collector sided processes to temperatures below 400°C, the capability to control the anode (or cathode) activation levels and for forming good Si/metal contacts is also strongly restricted. Besides, device optimization for improved static and dynamic performance is required with a number of limiting process options.

By utilizing high energy laser annealing (e.g. above 1 J/cm2) after implantation, higher activation levels are possible. However, this has only an impact on the Si wafer surface and does not improve the metal contact because the metallization is made in a later step. The metallization processing and sintering is still needed as a separate step.

Similar challenges are met when designing the fast recovery diodes based on thin wafer processing. In all these cases, the usage of an optimized laser annealing technology is inevitable for the creation of the p collector layer.

### Disclosure of Invention

It is an object of the invention to provide a method for manufacturing a power semiconductor device, which provides a better contact of the wafer to the electrode with improved process capability and better device performance than prior art methods.

This object is achieved by providing a method for manufacturing an inventive power semiconductor device comprising:
- providing a wafer of a first conductivity type, which wafer has a first main side and a second main side opposite to the first main side,
- applying a dopant of a second conductivity type, which is different from the first conductivity type, or of the first conductivity type on the second main side, for forming a layer of the first or second conductivity type, respectively,
- afterwards depositing a metal deposition layer with a metal having a melting point above 1200 °C on the second main side,
- annealing the metal deposition layer so that simultaneously an intermetal compound layer is formed at the interface between the metal deposition layer and the wafer and the dopant is diffused into the wafer,
- creating a first metal electrode layer on the second side.

The invention can exemplarily be applied to thin wafers having a thickness of at most 200 µm as they are used for low voltage IGBTS (voltages of up to 2000 V) or for low voltage diodes (also up to 2000 V). The process capability can be improved by the inventive manufacturing method and the device performance can also be improved compared to prior art SPT IGBTs and diodes.

By using the inventive method, the activation of the collector dopant (like boron or Aluminum as a p dopant; or: Phoshorous or Arsenic as an n dopant) can be greatly improved which is especially important when processing thin wafers and wafers of large diameters like exemplarily 200 mm or larger diameters.

The metal deposition layers have a high temperature melting point since depending on the duration and energy of the laser pulse high temperatures can be produced on the wafer surface. Even short, but high energy laser pulses produce temperatures higher than well above 1000 °C. Examplarily laser pulses having an energy > 1 J/cm2 are used. E.g. a very short (for example 200 ns) and high energy (2 J/cm²) laser pulse can produce surface temperatures exceeding 1300°C. Therefore, exemplarily, the metal deposition layer is made of a metal/ metals having a melting point higher than the temperature produced by the laser, e.g. higher than 1200 °C or even higher than 1300 °C.

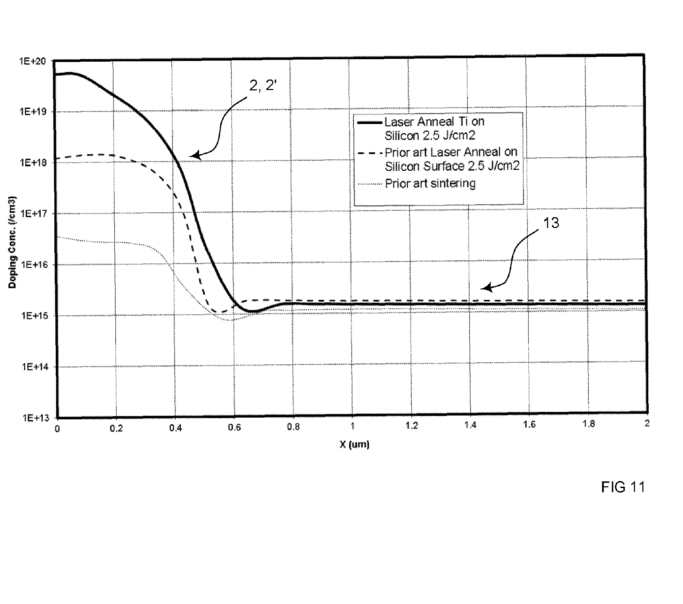

A major advantage is due to the fact that the metal deposition layer having a melting point above 1200 °C absorbs the laser beam (heat) much more than the wafer surface. Therefore, a better activation of the dopant is achieved and/or lower laser energies can be applied as shown in FIG 11.

Metals, which are exemplarily applied are Ti and Ni, which are capable of providing good contact Silicide layers with a Si wafer. These layers can also be used in addition to backside structures as needed for field charge extraction (FCE) concept diodes or reverse conducting IGBTs, which comprise alternating p and n areas on the collector side.

In case of the inventive method including a step of implantation of the dopant for forming a layer of the first or second conductivity type, the implantation step and the metal deposition step are performed in two different tools. If depositing is used as a method to apply the dopant, the metal deposition layer can be created in the same apparatus.

The laser anneal step is performed after a metal deposition layer is deposited on the wafer surface (p or n type layer). Hence a good activation level is achieved with lower laser energies (which is better from the process capability and surface damage after laser annealing) and a good contact is formed (by the intermetal compound layer and/or by a sinter step). FIG 11 shows the doping concentration achieved by prior art sintering compared to a prior art laser anneal and the improvement by adding an inventive Ti deposition layer before the laser anneal step. The doping concentration rises from about 5 * 10¹⁶ cm⁻³ to 1 * 10¹⁸ cm⁻³ for the prior art laser anneal and further to 8 * 10¹⁹ cm⁻³ for an inventive lase anneal and a wafer having a Ti deposition layer.

After the laser anneal step, the final soldering metals can be deposited such as Ti, Ni or Ag with a small anneal step. The same metal may be used as a metal deposition layer and as a first metal electrode layer.

For the method applying the dopant by deposition like evaporation or sputtering for forming the layer of the first or second conductivity type a single tool can be used for the deposition of the dopant and the deposition of the metal deposition layer.

### Brief Description of Drawings

The subject matter of the invention will be explained in more detail in the following text with reference to the attached drawings, in which:
- FIG 1: shows a method for manufacturing a prior art power semiconductor device;
- FIG 2: shows an inventive method for manufacturing a power semiconductor device;
- FIG 3: shows an alternative for step a) of FIG 2;
- FIG 4: shows an alternative for step b) of FIG 2;
- FIG 5: an alternative for step d) of FIG 2;
- FIG 6: another alternative for step d) of FIG 2;
- FIG 7-9: shows different inventive IGBTs;
- FIG 10: shows an inventive diode; and
- FIG 11: a graphics shows doping concentration versus depth in the wafer achieved with prior art methods and the inventive method.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

For manufacturing an inventive insulated gate bipolar transistor the following steps are performed.

An (n-) doped wafer 1 having a first and second main side 11, 15 opposite to the first main side 11 is provided. The wafer 1 may be made on a basis of a silicon or a wide bandgap wafer. Such part of wafer having unamended doping concentration in the finalized device forms a drift layer 10. On the second main side 15 an n dopant is applied and diffused into the wafer 1 for the creation of the buffer layer 13.

Alternatively, the following steps are directly performed on an (n-) doped wafer without creating a buffer layer on it, i.e. the step of creating a buffer layer is omitted and a non punch-through device is manufactured. In this case on the second side 15 the collector layer 2, 2' as described in the following is created directly neighboured to the (n-) doped drift layer 10.

Afterwards the following steps are performed for the creation of layers on the first main side 11. For forming a base layer 5 p dopants are applied on the first main side 11 and diffused into the wafer 1.

Then n type dopants for creation of the source regions 6 are implanted on the first main side 11 and annealed.

Afterwards the wafer is exemplarily thinned on the second main side 15 to leave a tail section of the buffer layer.

These steps are only meant as an example for the creation of the layers on the first main side 11 of the wafer and the buffer layer 13. Any other order (e.g. creating part of the layers on the first main side 11 at a later stage than described beforehand shall be covered by the invention. E.g. the first and second metal electrode layers 4, 8 may be created simultaneously.

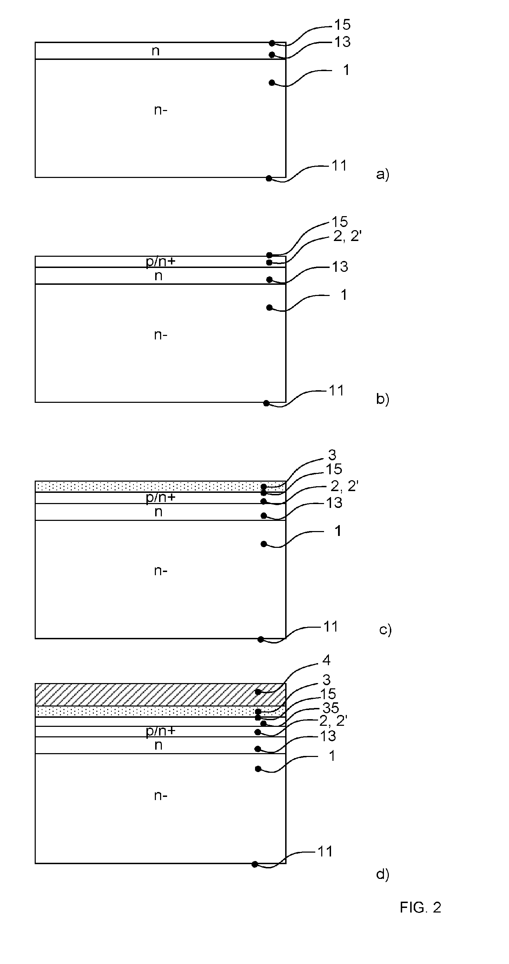

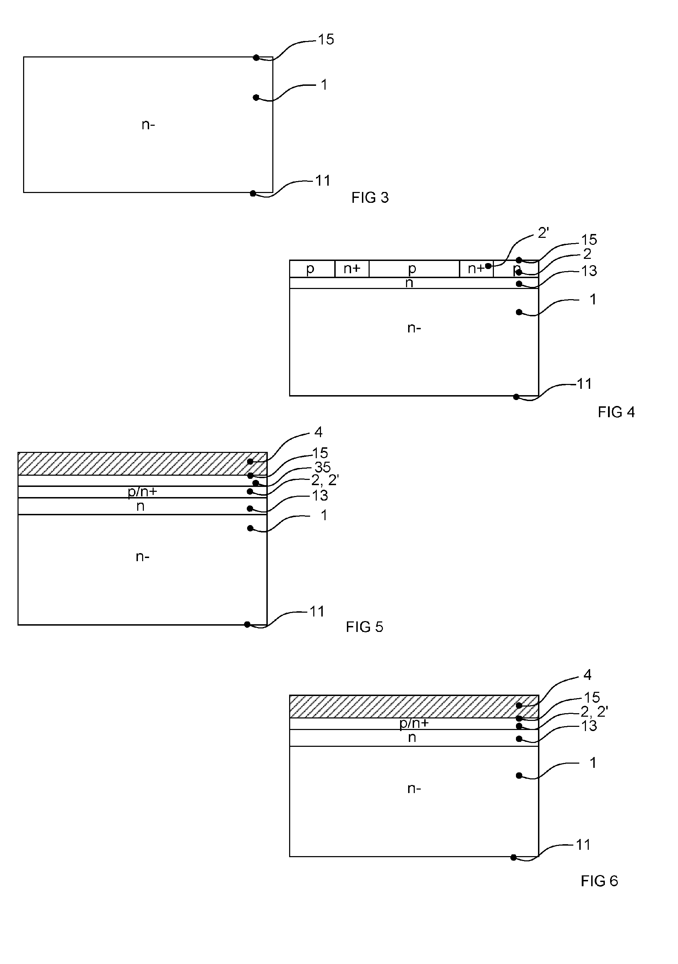

The inventive method disclosed below starts by providing a wafer which wafer has a first main side 11 and a second main side 15 opposite to the first main side 11, wherein the wafer has an n doped layer (which later forms the buffer layer) on the second main side 15 (FIG 2a). Alternatively, the inventive method may start by providing an (n-) doped wafer which does not have any differently doped layer on the second main side 15 as shown in FIG 3. In the Fig.s 2 to 6 only the second main sided layers have been shown. The layers on the first main side 11 are not part of these figures for clarity reasons.

For the creation of the layers on the second main side 15 the following steps are performed:
- applying a dopant of a second conductivity type, which is different from the first conductivity type, or of the first conductivity type on the second main side 15, for forming a layer 2 of the second or first conductivity type (FIG 2b),
- afterwards depositing a metal deposition layer 3 on the second main side 15 (FIG 2c),
- annealing the metal deposition layer 3 so that an intermetal compound layer 35 is formed at the interface between the metal deposition layer 3 and the wafer 1 and so that the dopant is diffused into the wafer 1,
- creating a first metal electrode layer 4 on the second side 15.

The dopant for the creation of the n or p doped layer layer 2,2' can be applied on the second main side 15 by deposition or implantation of the dopant. Depending on the semiconductor type the dopant is of n or p type. E.g. in case of the semiconductor being a diode the dopant may be of n type, in case of the semiconductor being an IGBT, a p type dopant is applied. Also pre-doped amorphous silicon (pre-doped either with n or p type ions) can be applied as a dopant.

In case of the semiconductor being a reverse conducting device, an n type dopant and another dopant of p type is applied so that n and p layers are created which alternate in a plane parallel to the second main side (FIG 4).

For depositing the metal deposition layer a metal having a melting point above 1200 °C like Titanium (melting point: 1660 °C) or Nickel (melting point: 1495 °C) is used. Examplarily the melting point lies above 1300 °C. Other metals that can be used are Palladium (melting point: 1552 °C) or Platin (melting point: 1772 °C). The thickness of the metal deposition layer is exemplarily between 20 to 200 nm, in particular between 50 to 100 nm. The annealing of the metal deposition layer 3 is exemplarily done by laser annealing.

The metal deposition layer 3 and the dopant are afterwards annealed by laser annealing. This is exemplarily done using an energy of 1 J/cm². By this laser annealing in case of the wafer being made of silicon, the metal forms a silicide layer (intermetal compound layer) together with the silicon. The intermetal compound layer 35 being formed at the interface between the metal deposition layer 3 and the wafer 1 shall mean that the metal diffuses from the metal deposition layer 3 into the wafer 1, i.e. the intermetal compound layer 35 is arranged below the metal deposition layer 3 and from the second main side 15 of the wafer to a depth. The thickness of the intermetal compound layer is the depth, up to which the layer 35 extends in the wafer from the wafer surface (second main side 15). It corresponds exemplarily to the thickness of the metal deposition layer up to 4 times the thickness of the metal deposition layer, exemplarily up to three times the thickness.

The intermetal compound layer is a layer, in which the metal from the metal deposition layer diffuses into the wafer and the metal forms a compound with the wafer material. In case of a silicon wafer silicides are formed. E.g. silicon forms with nickel NiSi, with titanium TiSi₂ and with platinum PtSi. The term "intermetal " is used in the present patent application as to define such a compound created by the diffusion of the metal of the metal deposition layer into the wafer material. It may also be called metal-wafer compound layer or simply metal-wafer layer.

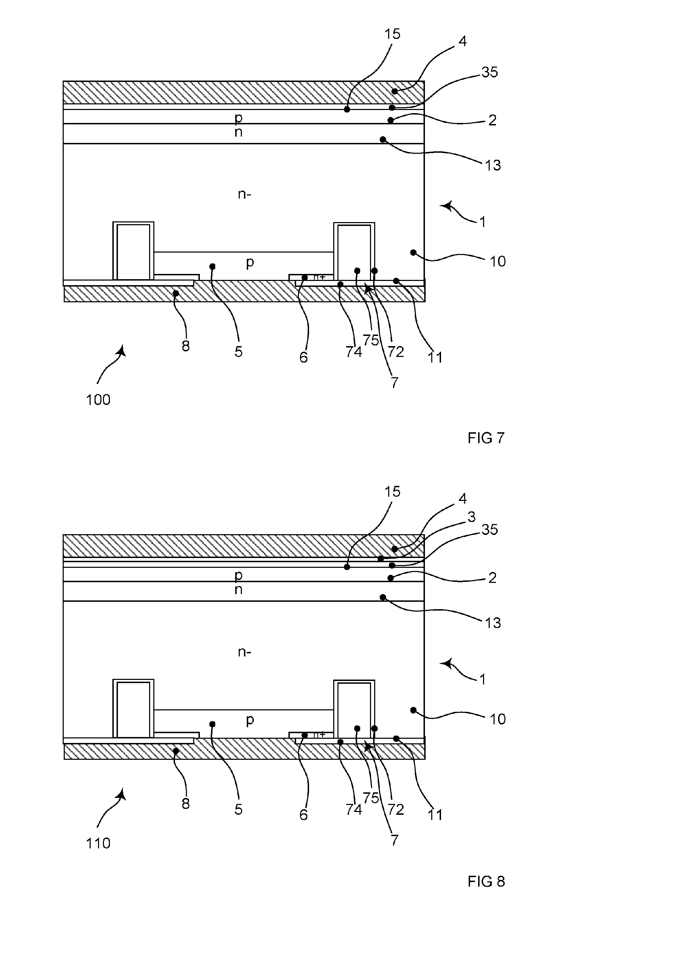

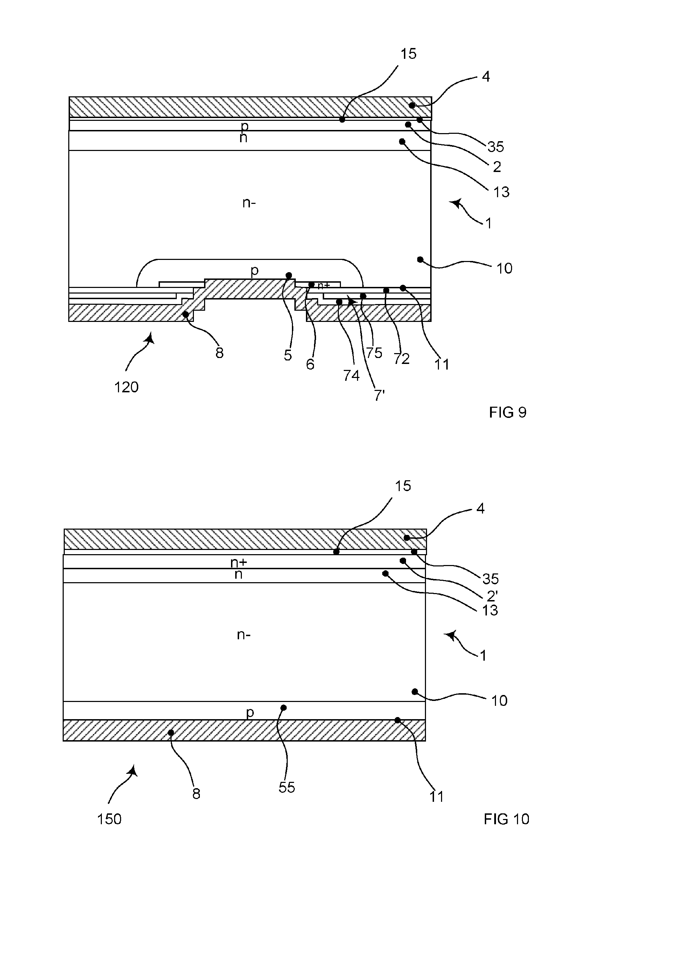

Before creating the first metal electrode layer 4 the intermetal compound layer 35 together with the metal deposition layer 3 may be removed (FIG 6). Alternatively, the intermetal compound layer 35 may be kept, whereas in this case the metal deposition layer 3 may either also be kept (FIG 2d), the inventive IGBT 110 having these layers e.g. shown in FIG 8) or be removed before creating the first metal electrode layer 4 (FIG 5; IGBT with intermetal layer 35, but without metal deposition layer e.g. FIG 7 showing IGBT 100, FIG 9 showing IGBT 120, or FIG 10 showing an inventive diode 150).

Examplarily, in a case in which the same metal is used for the metal deposition layer 3 and the metal electrode layer 4 the manufacturing step of removing the metal deposition layer 3 may be avoided. However, in cases in which different metals are used for the metal deposition layer 3 and the first metal electrode layer 4, the deposition layer 3 may also be kept so that the metal deposition layer 3, which is electrically conductive, forms part of the first metal electrode layer 4. Thus, the first metal electrode layer 4 forms a sandwiched layer.

After creation of the first metal electrode layer 4, the layer 4 may be sintered for further improving a reliable contact of the first metal electrode layer 4 to the wafer 1.

In FIG 7 an inventive power semiconductor device is shown in form of an insulated gate bipolar transistor 100, which comprises a second metal electrode layer 8 in form of an emitter electrode on the first main side 11 and a first metal electrode layer 4 in form of a collector electrode on the second main side 15, which second main side 15 is arranged opposite to the first main side 11. An (n-) doped drift layer 10 is arranged between the first main side 11 and the second main side 15. A p doped base layer 5 is arranged between the drift layer 10 and the first main side 11. The base layer 5 contacts the second metal electrode layer 8. At least one n doped source region 6 is arranged on the first main side 11.

The device comprises a gate electrode, either in form of a trench gate electrode 7 (FIG 7, 8) or a planar gate electrode 7' (FIG 9).

Such a trench gate electrode 7 comprises an electrically conductive layer 75 and a first electrically insulating layer 72, which surrounds and thus separates the electrically conductive layer 75 from the drift layer 10, the base layer 5 and the at least one source region 6. Typically, a second insulating layer 74 is arranged between the electrically conductive layer 75 and the second metal electrode layer 8. The trench gate electrode 7 is arranged laterally to the base layer 5 in a plane parallel to the first main side 11.

An IGBT 120 with planar gate electrode 7' is shown in FIG 9. The planar gate electrode 7' also comprises an electrically conductive layer 75, but in this case the gate electrode 7' is arranged on top of the wafer 1 on the first main side 11. A first electrically insulating layer 72 is arranged between the electrically conductive layer 75 and the wafer 1 such that it separates the electrically conductive layer 75 from the drift layer 10, the base layer 5 and the at least one source region 6. Typically, a second insulating layer 74 is arranged between the electrically conductive layer 75 and the second metal electrode layer 8.

The source region 6 is embedded into the base layer 5 such that the source region 6 contacts the second metal electrode layer 8.

On the second main side 15 a p doped layer 2 in form of a collector layer is arranged. An n doped buffer layer 13 having higher doping concentration than the drift layer 10 may be arranged between the drift layer 10 and the collector layer.

The doping concentration of the source region 6 is higher than of the base layer 5. Exemplary doping concentrations for the source region 6 higher than 1*10¹⁸ cm⁻³ and smaller than 1*10²¹ cm⁻³, exemplarily between 1*10¹⁹ cm⁻³ and 1*10²⁰ cm⁻³.

The doping concentration of the base layer 5 and the drift layer 10 can be freely chosen due to the application needs and the rules for the doping concentrations given above. For devices above 600 V the doping concentration of the drift layer is typically below 5*10¹⁴ cm⁻³. The base layer 5 exemplarily has a doping concentration below 5*10¹⁸ cm⁻³.

The structures as described above form an active cell. The IGBT device may comprise only one active cell as disclosed above, but it is also possible that the device comprises at least two or more such active cells, i.e. the active cells can be repetitively arranged in one wafer.

In FIG 10 an inventive diode 150 is shown, which comprises on the first main side a p doped anode layer 55. On second main side 15 an n doped layer 2', on which during manufacturing the metal deposition layer 3 has been applied. Depending on the application, the buffer layer 13 present in FIG 110 between drift layer 10 and first layer 2' may also be omitted. In FIG 10 the device comprises the intermetal compound layer 35, but as stated before this layer may also have been removed or the metal deposition layer 3 may also have been kept.

In another embodiment, the conductivity types are switched, i.e. all layers of the first conductivity type are p type (e.g. the wafer 1) and all layers of the second conductivity type are n type (e.g. layer 2, if layer 2 is of a different conductivity type than wafer 1).

It should be noted that the term "comprising" does not exclude other elements or steps and that the indefinite article "a" or "an" does not exclude the plural. Also elements described in association with different embodiments may be combined. It should also be noted that reference signs in the claims shall not be construed as limiting the scope of the claims.

It will be appreciated by those skilled in the art that the present invention can be embodied in other specific forms without departing from the spirit or essential characteristics thereof. The presently disclosed embodiments are therefore considered in all respects to be illustrative and not restricted. The scope of the invention is indicated by the appended claims rather than the foregoing description and all changes that come within the meaning and range and equivalence thereof are intended to be embraced therein.

### Reference List

- 1: wafer
- 10: drift layer
- 11: first main side
- 13: buffer layer
- 15: second main side
- 100, 110, 120: inventive IGBT
- 150: inventive diode
- 2, 2': layer of first or second conductivity type
- 3: metal deposition layer
- 35: intermetal compound layer
- 4: first metal electrode layer
- 5: base layer
- 55: anode layer
- 6: source region
- 7, 7': gate electrode
- 72: first insulating layer
- 74: second insulating layer
- 75: electrically conductive layer
- 8: second metal electrode layer

## Claims

1. A method for manufacturing a power semiconductor device comprising the following steps:
- providing a wafer (1) of a first conductivity type, which wafer has a first main side (11) and a second main side (15) opposite to the first main side (11),
- applying on the second main side (15) at least one of a dopant of the first conductivity type for forming a layer (2') of the first conductivity type and a dopant of a second conductivity type, which is different from the first conductivity type, for forming a layer (2) of the second conductivity type,
- afterwards depositing a metal deposition layer (3) with a metal having a melting point above 1200 °C on the second main side (15),
- annealing the metal deposition layer (3) so that simultaneously an intermetal compound layer (35) is formed at the interface between the metal deposition layer (3) and the wafer (1) and the at least one dopant is diffused into the wafer (1),
- creating a first metal electrode layer (4) on the second side (15).

2. The method according to claim 1, **characterized by** using Titanium or Nickel for depositing the metal deposition layer (3).

3. The method according to any of the claims 1 or 2, **characterized by** annealing the metal deposition layer (3) by laser annealing.

4. The method according to any of the claims 1 to 3, **characterized by** depositing the metal deposition layer (3) having a thickness between 20 to 200 nm, in particular between 50 to 100 nm.

5. The method according to any of the claims 1 to 4, **characterized by** applying the at least one dopant by implanting or depositing the dopant.

6. The method according to claim 1 to 4, **characterized by** applying the at least one dopant by depositing pre-doped amorphous silicon as dopant.

7. The method according to any of the claims 1 to 6, **characterized by** sintering the first metal electrode layer (4).

8. The method according to any of the claims 1 to 7, **characterized by** removing the intermetal compound layer (35) and the metal deposition layer (3) before creating the first metal electrode layer (4).

9. The method according to any of the claims 1 to 7, **characterized by** removing the metal deposition layer (3) and keeping the intermetal compound layer (35) before creating the first metal electrode layer (4).

10. The method according to any of the claims 1 to 9, **characterized by** depositing the metal deposition layer (3) with a metal having a melting point above 1300 °C on the second main side (15).

11. The method according to any of the claims 1 to 10, **characterized by** providing a silicon or wide bandgap wafer as the wafer (1).

12. The method according to any of the claims 1 to 11, **characterized by** introducing a buffer layer (13)) into the wafer (1) before providing the wafer (1), which buffer layer (13) is introduced on the drift layer (13) on the second main side (15) and which buffer layer (13) has higher doping concentration than the drift layer (10).

13. The method according to any of the claims 1 to 12, **characterized by** manufacturing an IGBT, in particular a reverse conducting IGBT, or a diode as the power semiconductor device.

14. A power semiconductor device, **characterized in that** the device comprises a wafer (1) having a first main side (11) and a second main side (15) opposite to the first main side (11), which wafer (1) comprises on the second main side (15) at least one of a layer (2, 2') of a first conductivity type and a layer of a second conductivity type, which is different from the first conductivity type, which wafer (1) comprises on the second main side (15) a first metal electrode layer (4), wherein an intermetal compound layer (35) with a metal having a melting point above 1200 °C is arranged between the first metal electrode layer (4) and the at least one of the layer (2') of the first conductivity type and the layer (2) of the second conductivity type.

15. The power semiconductor device according to claim 14, **characterized in that** the device comprises a metal deposition layer (35) between the intermetal compound layer (35) and the first metal electrode layer (8), which metal deposition layer (3) comprises the same metal as the intermetal compound layer (35).
